# EUROPEAN PATENT SPECIFICATION

(11) **EP 1 167 568 B1**
(45) Date of publication and mention of the grant of the patent: **07.06.2006**
(21) Application number: 01114658.6
(22) Date of filing: 19.06.2001
(51) Int. Cl.: C23C 16/44, H01L 21/316

(54) **Heat treatment apparatus and cleaning method of the same**
Wärmebehandlungsanlage und Verfahren zu ihrer Reinigung
Dispositif de traitement thermique et procédé pour le nettoyer

(30) Priority: 21.06.2000 JP 2000186942; 25.07.2000 JP 2000223233
(43) Date of publication of application: 02.01.2002
(73) Proprietor: TOKYO ELECTRON LIMITED, Tokyo-to (JP)
(72) Inventor: Takahashi, Yutaka, Tokyo Electron Tohoku Limited, Esashi-Shi, Iwate-Ken (JP); Hitoshi, Kato, Tokyo Electron Tohoku Limited, Esashi-Shi, Iwate-Ken (JP); Yamamoto, Hiroyuki, Tokyo Electron Tohoku Limited, Esashi-Shi, Iwate-Ken (JP); Ishiti, Katsutoshi, Tokyo Electron Tohoku Limited, Esashi-Shi, Iwate-Ken (JP); Nishimura, Kazuaki, Tokyo Electron Tohoku Limited, Esashi-Shi, Iwate-Ken (JP); Spaull, Phillip, Tokyo Electron Tohoku Limited, Esashi-Shi, Iwate-Ken (JP)
(74) Representative: Liesegang, Eva

(56) References cited:
- WO-A-01/33616
- US-A- 5 647 945
- PATENT ABSTRACTS OF JAPAN vol. 2000, no. 05, 14 September 2000 (2000-09-14) & JP 2000 040685 A (TOSHIBA CORP), 8 February 2000 (2000-02-08)
- PATENT ABSTRACTS OF JAPAN vol. 1996, no. 12, 26 December 1996 (1996-12-26) & JP 08 209350 A (MITSUBISHI ELECTRIC CORP), 13 August 1996 (1996-08-13)
- PATENT ABSTRACTS OF JAPAN vol. 008, no. 273 (C-256), 13 December 1984 (1984-12-13) & JP 59 143073 A (SEIKO DENSHI KOGYO KK), 16 August 1984 (1984-08-16)

## Description

### Background of the Invention

### Field of the Invention

The present invention relates to a heat treatment apparatus for removing a pollutant on a film requiring no treating device or an object to be processed and its cleaning method.
More particularly, the present invention relates to a cleaning method of a heat treatment apparatus according to the preamble of claim 1 and to a heat treatment apparatus according to the preamble of claim 5. A method and apparatus of this type are known from patent abstracts of Japan, Vol. 2000, No. 05, 14 September 2000 and JP 2000 040685 A.

### Description of the Prior Art

Generally, to manufacture a semiconductor device, the film forming process and pattern etching process are performed repeatedly for a semiconductor wafer which is an object to be processed and a desired device is manufactured. Particularly, with respect to the film forming process, the specification thereof, that is, the design rule is becoming severe year by year due to high density and high integration of semiconductor devices. For example, even for a very thin oxide film such as a capacitor insulating film or a gate insulating film of a device, a thinner film is required, and a higher insulation property is required at the same time.

Under such conditions, instead of a silicone oxide film and a silicone nitride film which are conventionally used, as materials having better insulating properties and electrical characteristics such as a dielectric constant, metallic oxide films, for example, a tantalum oxide film (Ta₂O₅) and a composite metallic oxide film having a larger dielectric constant than the tantalum oxide film, for example, SrTiO₃ (hereinafter referred to as STO) and BaₓSrᵢ₋ₓTiO₃ (hereinafter referred to as BSTO) have been studied. In addition to them, various metallic films and metallic oxide films have been studied as a dielectric layer.

Meanwhile, a batch type heat treatment apparatus such as a film forming apparatus has a vertical or horizontal cylindrical treatment vessel made of quartz. In such a batch type heat treatment apparatus, to remove an unnecessary film adhered to the inner wall of the treatment vessel or a wafer boat, a cleaning process of removing such an unnecessary film is performed periodically or irregularly.

In the cleaning process, large-scale wet cleaning is developed for removing the treatment vessel itself, immersing the treatment vessel in a cleaning solution, thereby removing an unnecessary film. Simple dry cleaning requiring no long processing time is developed for flowing cleaning gas such as ClF₃, HCL, Cl₂, NF₃, or F₂ in the state that the treatment vessel is kept assembled and for removing an unnecessary film.

From the viewpoint of improvement of the productivity (throughput) of a semiconductor device as a whole, it is required to use the dry cleaning and remove an unnecessary film more effectively.

However, in the case of forming composite metallic oxide films such as STO or BSTO aforementioned which have been studied recently or new metallic oxide films, there is a case that such an unnecessary film cannot be removed fully. For example, generally, as the temperature of the treatment vessel is increased at the time of cleaning, the reactivity of the cleaning gas is increased. As a result, a new film species which has been difficult to be removed until now, can be removed, thereby the cleaning efficiency is increased. However, at the same time, the treatment vessel made of quartz and the wafer boat made of quartz holding a semiconductor wafer are likely to be damaged by the cleaning gas and the temperature of the treatment vessel cannot be increased excessively.

Further, although it is desired to remove an unnecessary film such as a silicone oxide film or a silicone nitride film, which is conventionally used, more effectively and in a shorter time, as mentioned above, when the temperature is increased, the treatment vessel itself is caused great damage. Therefore, although depending on the cleaning gas species, the temperature cannot be increased to, for example, 800°C or more and the cleaning efficiency cannot be improved more.

Furthermore, in the vicinity of the introduction section of the cleaning gas, the gas is introduced in at a temperature close to the normal temperature, so that a problem arises that the temperature of the cleaning gas is partially lowered, thereby an unnecessary film in the vicinity of the gas introduction section can not be effectively removed fully.

### Summary of the Invention

The present invention provides a cleaning method of a heat treatment apparatus according to claim 1 and a heat treatment apparatus as defined in claim 5.

The present invention was developed to consider and solve the aforementioned problems effectively and is intended to provide a heat treatment apparatus for effectively removing an unnecessary film in a treatment vessel made of quartz without damaging the treating device and effectively removing a pollutant on an object to be processed and a cleaning method therefor.

The present invention is a cleaning method of a heat treatment apparatus for feeding cleaning gas in a treatment vessel is heated and kept and removing an unnecessary film in the treatment vessel, comprising the steps of preheating cleaning gas outside the treatment vessel and feeding preheated cleaning gas into the treatment vessel and heating and keeping the inside of the treatment vessel at a predetermined temperature.

The present invention is a cleaning method of a heat treatment apparatus, wherein a treatment vessel is heated and kept at a predetermined temperature in the state that a holding tool of an object to be processed is contained in the treatment vessel.

The present invention is a cleaning method of a heat treatment apparatus, wherein the cleaning gas is preheated up to the activation capability temperature of the cleaning gas at the preheating step.

The present invention is a cleaning method of a heat treatment apparatus, wherein the cleaning gas is preheated up to the heat decomposition temperature of the cleaning gas at the preheating step.

The present invention is a cleaning method of a heat treatment apparatus, wherein the cleaning gas includes ClF₃ and is preheated up to the activation capability temperature of ClF₃ in a range of 200 to 400°C at the preheating step.

The present invention is a cleaning method of a heat treatment apparatus, wherein the cleaning gas includes ClF₃ and is preheated up to the heat decomposition temperature of ClF₃ in a range of 300 to 1000°C at the preheating step.

The present invention is a cleaning method of a heat treatment apparatus, wherein an unnecessary film in a treatment vessel is a same kind of film as a film formed on the surface of an object to be processed in the treatment vessel.

The present invention is a cleaning method of a heat treatment apparatus, wherein a treatment vessel is made of quartz or SiC.

The present invention is a cleaning method of a heat treatment apparatus for feeding cleaning gas in a treatment vessel containing an object to be processed and removing a pollutant on the object to be processed in the treatment vessel, comprising the steps of preheating cleaning gas up to the activation capability temperature of cleaning gas outside the treatment vessel, and feeding preheated cleaning gas into the treatment vessel and heating and keeping the inside of the treatment vessel at a predetermined temperature.

The present invention is a cleaning method of a heat treatment apparatus, wherein preheating cleaning gas includes a hydrochloric acid, and is heated up to the activation capability temperature of hydrochloric acid of at least 800°C, and the inside of the treatment vessel is heated and kept at 700°C to 1000°C.

The present invention is a cleaning method for a heat treatment apparatus, wherein a pollutant on an object to be processed is at least one of iron, copper, aluminum, and tungsten.

The present invention is a heat treatment apparatus comprising a treatment vessel having a holding tool for an object to be processed, a treatment vessel heater arranged outside the treatment vessel for heating the treatment vessel, a cleaning gas feed means for feeding cleaning gas into the treatment vessel, and a cleaning gas heater connected to the cleaning gas feed means for preheating cleaning gas outside the treatment vessel, wherein the cleaning gas heater and treatment vessel heater are controlled by a control means.

The present invention is a heat treatment apparatus, wherein an object to be processed is held by a holding tool, and cleaning gas is preheated by a cleaning gas heater up to the activation capability temperature so that a pollutant on the object to be processed is removed.

The present invention is a heat treatment apparatus, wherein the cleaning gas includes a hydrochloric acid and the control means controls the cleaning gas heater so as to heat the cleaning gas up to the activation capability temperature of at least 800°C, and controls a treatment vessel heater so as to heat the treatment vessel to 700°C to 1000°C.

The present invention is a heat treatment apparatus, wherein a pollutant on an object to be processed is at least one of iron, copper, aluminum, and tungsten.

The present invention is a heat treatment apparatus, wherein the treating device is composed of an inner tube for containing an object to be processed and an outer tube having a ceiling covering the inner tube, and a cleaning feed means is interconnected into the inner tube.

The present invention is a heat treatment apparatus, wherein on the downstream side of a cleaning gas heater, an orifice is installed to give a flow path resistance to cleaning gas.

According to the present invention, without causing damage to the treatment vessel or the treatment vessel and the holding tool for an object to be processed, the removal rate of an unnecessary film can be improved and an unnecessary film which cannot be removed by the conventional method can be removed effectively.

According to the present invention, cleaning gas is heated to the activation capability temperature and the heated cleaning gas is fed to the treatment vessel. The temperature in the treatment vessel is heated to a predetermined temperature, for example, the temperature for keeping the activation state of the cleaning gas. Therefore, the cleaning gas is fed into the treatment vessel in the activated state and kept in the activated state even in the treatment vessel. The cleaning gas in the activated state is reacted with a pollutant on an object to be processed in this way, so that the reaction is promoted. Therefore, the removal efficiency of a pollutant adhered onto the object to be processed can be improved.

According to the present invention, cleaning gas is heated to the activation capability temperature by the cleaning gas heater controlled by the control means and the heated cleaning gas is fed into the treatment vessel by the cleaning gas feed means. Further, the temperature in the treatment vessel by the treatment vessel heater is heated to a predetermined temperature, for example, the temperature for keeping the activation state of the cleaning gas by the control means. Therefore, the cleaning gas is fed into the treatment vessel in the activated state and kept in the activated state even in the treatment vessel. The cleaning gas in the activated state is reacted with a pollutant in this way, and therefore the reaction is promoted. Thus, the removal efficiency of a pollutant adhered to an object to be processed can be improved.

### Brief Description of the Drawings

Fig. 1 is a schematic view showing a heat treatment apparatus in the first embodiment of the present invention.
Fig. 2 is a drawing showing a heat treatment apparatus of a single-tube structure having an outer cylinder made of quartz.
Fig. 3 is a drawing showing another heat treatment apparatus of a single-tube structure.
Fig. 4 is a schematic view showing a heat treatment apparatus in the second embodiment of the present invention.
Fig. 5 is a table showing the relationship between the temperature of the heater and the temperature of the reaction tube (treatment vessel) in the second embodiment of the present invention.

### Description of the Preferred Embodiments

### First Embodiment

The first embodiment of the heat treatment apparatus and its cleaning method relating to the present invention will be described in detail hereunder with reference to the accompanying drawings.

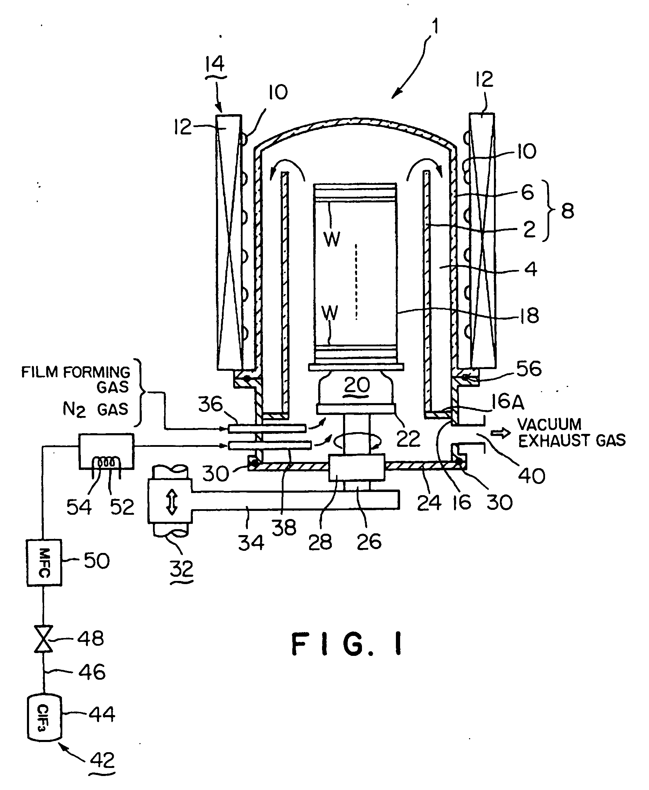

Fig. 1 is a schematic view showing a heat treatment apparatus (film forming apparatus) for executing the cleaning method relating to the present invention. Here, as a heat treatment apparatus 1, an example of a vertical film forming device using LP-CVD will be explained. As shown in the drawing, the heat treatment apparatus 1 has a treatment vessel 8 of a double-tube structure composed of a cylindrical inner tube 2 made of quartz and an outer tube 6 made of quartz arranged concentrically outside the inner tube 2 to form a predetermined gap 4 therebetween and the outside of the treatment vessel 8 is covered with a heating unit 14 having a heating means (treatment vessel heater) 10 such as a heater and a heat insulating material 12. The heating means 10 is installed on the overall inner surface of the heat insulating material 12.

The lower end of the treatment vessel 8 is supported by a cylindrical manifold 16, for example, made of stainless steel, and the lower end of the inner cylinder 2 is supported by a ring-shaped support plate 16A projecting internally from the inner wall of the manifold 16, and a wafer boat 18 made of quartz is installed as a holding tool for objects to be processed for loading a plurality of semiconductor wafers W as objects to be processed from underneath the manifold 16 so as to be movable vertically and removable freely.

The wafer boat 18 is mounted on a turn table 22 via an insulating cylinder 20 made of quartz and the turn table 22 is supported on a revolving shaft 26 passing through a cover 24 for opening or closing a lower end opening of the manifold 16.

A magnetic fluid seal 28 is provided, so as to surround the revolving shaft 26, for example, and supports the revolving shaft 26 air tightly so as to rotate freely. Further between the peripheral part of the cover 24 and the lower end of the manifold 16, a seal member 30 composed of, for example, an O-ring is provided to keep a sealing property inside the vessel 8.

The revolving shaft 26 is attached to the end of an arm 34 supported by an elevating mechanism 32 such as a boat elevator so as to move the wafer boat 18 and the cover 24 integratedly up and down.

On the side of the manifold 16, a gas introduction nozzle 36 for introducing film forming gas and inactive gas, for example, N₂ gas into the inner cylinder 2, a cleaning gas introduction nozzle 38 for introducing cleaning gas at the time of dry cleaning in the treatment vessel 8, and an exhaust port 40 for exhausting an atmosphere in the treatment vessel 8 from the bottom of the gap 4 between the inner cylinder 2 and the outer cylinder 6 are provided respectively. An evacuation system is connected to the exhaust port 40, via a vacuum pump not shown in the drawing. Further, a cleaning gas feed means 42 is connected to the cleaning gas introduction nozzle 38. The cleaning gas feed means 42 has a gas path 46 connected to a cleaning gas source 44 and an on-off valve 48, a flow rate controller 50 for controlling the flow rate of cleaning gas such as a mass flow controller, and a gas heating mechanism 52 on the downstream side of the flow rate controller 50 for preheating flowing cleaning gas to a predetermined temperature are installed on the gas path 46. The cleaning gas whose flow rate is controlled to a desired value is heated to a predetermined temperature and flow into the treatment vessel 8. The gas heating mechanism 52 has a gas heater (cleaning gas heater) 54 which is to be controlled. Any internal structure thereof may be used so long as it can heat cleaning gas. Here, as cleaning gas, for example, ClF₃ gas of chlorine trifluoride is used. As cleaning gas, chlorine fluoride (ClF) may be used. In the drawing, numeral 56 indicates a seal member such as an O-ring lying between the lower end of the outer cylinder 6 and the upper end of the manifold 16.

Next, the film forming process using the apparatus structured as mentioned above will be explained.

Firstly, when the wafer boat (holding tool for objects to be processed) 18 for holding semiconductor wafers (objects to be processed) W is in the unloaded state and the film forming apparatus is in the standby state, the treatment vessel 8 is kept at the film forming process temperature, for example, 600ₒC or lower. Unprocessed wafers W are loaded on the wafer boat 18 from a wafer carrier not shown in the drawing, and the wafer boat 18 having the loaded wafers W at a normal temperature is moved up and loaded in the treatment vessel 8 from underneath, and the lower end opening of the manifold 16 is closed by the cover 24, thereby the treatment vessel 8 is closed tightly.

Then, the treatment vessel 8 is internally kept at predetermined film forming process pressure and stands by until the wafer temperature rises and is stabilized at a predetermined film forming process temperature and then predetermined film forming gas is introduced into the treatment vessel 8 from the processing gas introduction nozzle 36. Film forming gas is introduced onto the inner bottom of the inner cylinder 2 from the processing gas introduction nozzle 36, then moves upward by carrying out a film forming reaction in contact with the wafers W rotating in the inner cylinder 2, moves downward in the gap 4 between the inner cylinder 2 and the outer cylinder 6 from the ceiling, and is ejected outside the container from the exhaust port 40. As a result, a predetermined film is formed on each of the wafers W.

The aforementioned is the flow of film forming process. However, when such a film forming process is repeated, along the flowing direction of film forming gas, an unnecessary film is formed inevitably on the wall surface of the quartz member. The unnecessary film is adhered onto the wafer boat 18, the inner and outer surfaces of the inner cylinder 2, the inner surface of the outer cylinder 6, and the surface of the insulating cylinder 20.

Therefore, when the film forming process is performed to a certain extent, the cleaning operation for removing the unnecessary adhered film causing particles is performed.

The cleaning operation is performed, as an example, in the state that the empty wafer boat 18 holding no wafers is introduced into the treatment vessel 8. Namely, after the aforementioned film forming process is performed, the elevating mechanism 32 is driven, thereby the wafer boat 18 is unloaded from the treatment vessel 8. Thereafter, the processed wafers W contained in the wafer boat 18 are all transferred into a wafer carrier (not shown in the drawing) using a transfer mechanism not shown in the drawing, thereby the wafer boat 18 becomes empty. After the transfer of the processed wafers W is completed like this, the elevating mechanism 32 is driven again, thereby the empty wafer boat 18 is loaded in the treatment vessel 8 and the lower end opening of the manifold 16 is closed tightly by the cover 24.

The treatment vessel 8 is kept at a predetermined temperature, for example, within the range from 200 to 1000°C by a heating means 10, and ClF₃ gas as cleaning gas whose flow rate is controlled is fed from the cleaning gas introduction nozzle 38 into the inner bottom of the inner cylinder 2, and at the same time, when necessary, inactive gas, for example, N₂ gas is introduced as diluent gas from the processing gas introduction nozzle 36. In this case, the aforementioned cleaning gas is preheated up to a predetermined temperature by the gas heating mechanism 52 immediately before it is introduced in the treatment vessel 8.

The aforementioned inactive gas and the preheated cleaning gas to a predetermined temperature beforehand are mixed in the treatment vessel 8 and the mixed gas moves upward in the inner cylinder 2 in the same way as with the aforementioned film forming gas, reaches the ceiling, turns back here, moves downward in the gap 4 between the inner cylinder 2 and the outer cylinder 6, and is ejected outside the container from the exhaust port 40. In the path through which ClF₃ gas flows, an unnecessary film adhered to the wall surface is reacted and etched by ClF₃ gas and removed slowly.

In this case, as mentioned above, the cleaning gas is preheated up to a predetermined temperature immediately before it is introduced in the treatment vessel 8, so that an unnecessary film is in a fully reactive state and can be removed effectively and rapidly and the cleaning can be executed effectively, for example, in a short time.

Concretely, the temperature of cleaning gas by heating in the gas heating mechanism 52 may be a temperature at which the kinetic energy of gas molecules just increases, or a temperature at which gas molecules are excited in the high energy state and activated so that they are chemically reacted very easily, for example, in the case of ClF₃ gas, about 200 to 400°C, or furthermore, a temperature at which gas molecules are decomposed to elements, for example, in the case of ClF₃ gas, about 300 to 1000°C.

In the cleaning method of the present invention, cleaning gas is preheated to a predetermined temperature immediately before it is introduced in the treatment vessel 8.

When the cleaning gas at the normal temperature or so is introduced like the conventional method, the temperature in the neighborhood of the gas introduction section is lowered partially and an unnecessary film on the part may not be removed fully, while in the method of the present invention, the temperature in the neighborhood of the gas introduction section is not lowered, accordingly an unnecessary film on the part can be removed almost fully.

Further, when the cleaning process conditions such as the temperature of the treatment vessel 8 are set in the same way as with the conventional method and the treatment vessel 8 is cleaned, the cleaning rate (film removal rate) is increased by preheating cleaning gas according to the present invention, and the cleaning time can be shortened, and moreover, the component part made of quartz is not caused large damage.

Further, in the conventional method, an unnecessary film cannot be removed unless the cleaning temperature is increased though the damage of the component part made of quartz is large, while in the method of the present invention, even if the cleaning temperature is set low, the temperature of cleaning gas is increased by preheating so as to fully react with an unnecessary film, so that the surface of the component part made of quartz is not given large damage, and the unnecessary film is removed effectively, thereby the treatment vessel 8 can be cleaned.

Furthermore, even when the upper limit temperature which can be increased by the heater 14 is about 800 to 1000°C from the viewpoint of the constitution of the electric power device and an unnecessary film cannot be removed at such a temperature, in the method of the present invention, the cleaning process temperature (temperature of the treatment vessel 8 and others) can be kept at about 800 to 1000°C as mentioned above and cleaning gas is preheated to a temperature higher than that of the vessel 8, for example, about 1200°C, so that no damage is given to the component part made of quartz and an unnecessary film which cannot be removed by the conventional method can be removed.

Further, although the pressure in the treatment vessel in the conventional cleaning method is about several hundreds Pa (several Torr), when it is set to several tens kPa (several hundreds Torr), an unnecessary film can be removed more effectively and the cleaning effect can be improved more.

Here, unnecessary films to be cleaned are films used, for example, in MOSFET such as an Si film, an SiO₂ film, an Si₃N₄ film, a BSTO (BaₓSr₁₋ₓTiO₃) film, an STO (SrTiO₃) film, a TiN film, an Ru film, an RuO₂ film, a Ti₂O₅ film, a W film, and a WSi film.

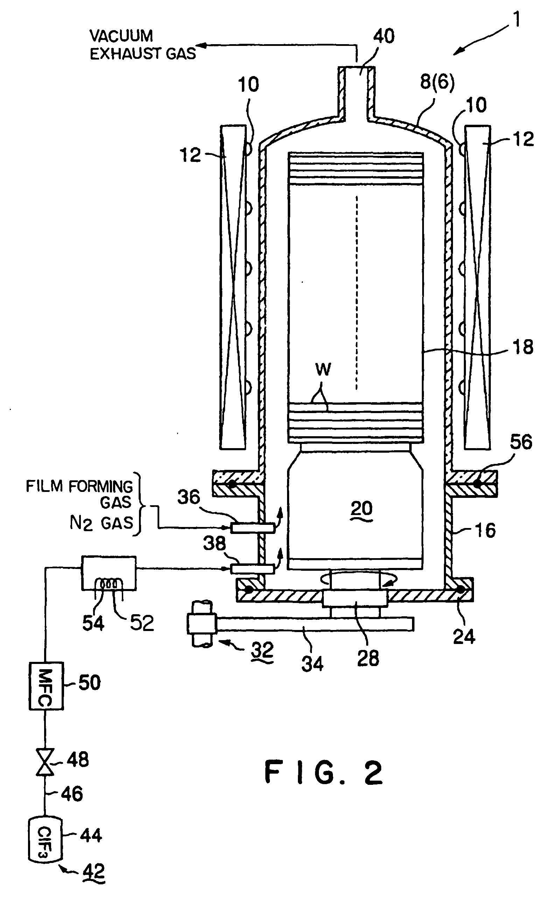

In the embodiment aforementioned, an example of a case that the vertical treatment vessel 8 has a double-tube structure composed of the inner cylinder 2 and the outer cylinder 6 is explained. However, the present invention is not limited to the treatment vessel and the present invention can be applied to a case as shown in Fig. 2 that the treatment vessel 8 is a film forming apparatus of a single-tube structure composed of, for example, only the outer cylinder 6 made of quartz. In Fig. 2, the same numeral is used to each of the same component parts of the apparatus shown in Fig. 1 and the detailed explanation will be omitted. In this case, as mentioned above, the treatment vessel 8 is composed of, for example, one outer cylinder 6 made of quartz. The exhaust port 40 with a large aperture is provided on the upper end of the outer cylinder 6 and evacuates the treatment vessel 8.

In this case, at the time of cleaning, cleaning gas preheated moves upward in the treatment vessel 8 from the cleaning gas introduction nozzle 36 provided on the manifold 16, removes an unnecessary film adhered to the surface of the component part made of quartz, and is ejected outside the container from the exhaust port 40 at the upper end.

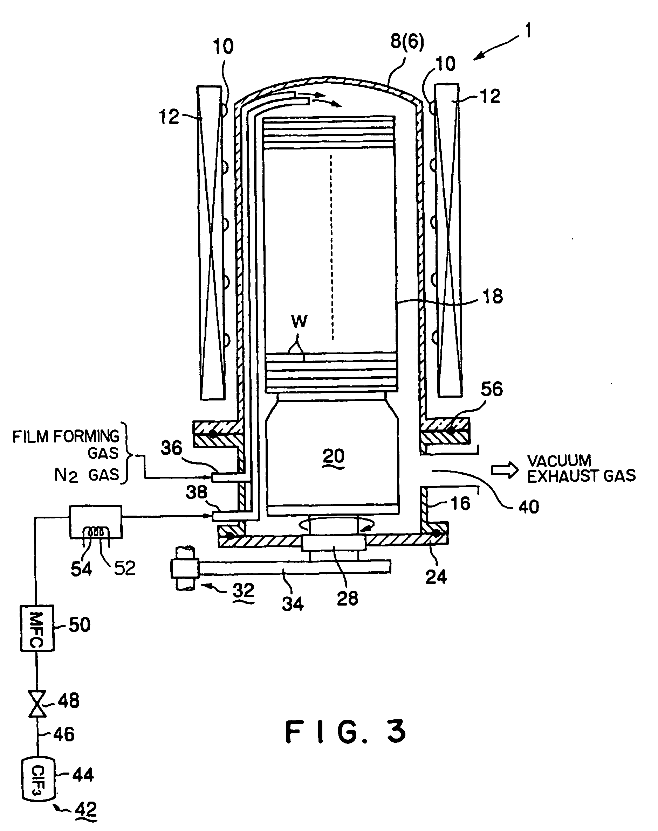

In the example of the apparatus of a single-tube structure shown in Fig. 2, the exhaust port 40 is provided at the upper end of the treatment vessel 8. However, the present invention is not limited to the apparatus in Fig. 2. As shown in Fig. 3, the exhaust port 40 may be provided on the manifold 16 in the same way as the case shown in Fig. 1, and the gas introduction nozzle 36 and the cleaning gas introduction nozzle 38 extend upward along the inner wall of the treatment vessel of a single-tube structure and the nozzle ends are positioned on the ceiling of the treatment vessel 8. Cleaning gas preheated flows along the cleaning gas introduction nozzle 36 and then moves down in the treatment vessel 8. The cleaning gas removes an unnecessary film adhered to the surface of the component part made of quartz, and is ejected outside the vessel 8 from the exhaust port 40 in the manifold 16.

Even in the apparatus shown in Figs. 2 and 3, the same operation effect as that shown in Fig. 1 is performed and for example, without damage caused to the surface of the member made of quartz, an unnecessary film can be removed effectively.

The method of the present invention is explained above using an example of the batch type film forming apparatus for processing a plurality of semiconductor wafers at a time. However, the present invention is not limited to this type of apparatus and needless to say, the method of the present invention can be applied to a single-wafer processing type film forming device for processing semiconductor wafers one by one.

Objects to be processed are not limited to semiconductor wafers and needless to say, LCD substrates and glass substrates can be used.

Further, the treatment vessel 8 of a double-tube structure or a single-tube structure may be made of SiC.

As explained above, according to the cleaning method of the present invention, the following superior operation effect can be produced.

Since the cleaning gas is preheated and introduced into the treatment vessel, without causing damage to the treatment vessel or the treatment vessel and the holding tool for an object to be processed, the removal rate of an unnecessary film can be improved and an unnecessary film which cannot be removed by the conventional method can be removed effectively.

### Second Embodiment

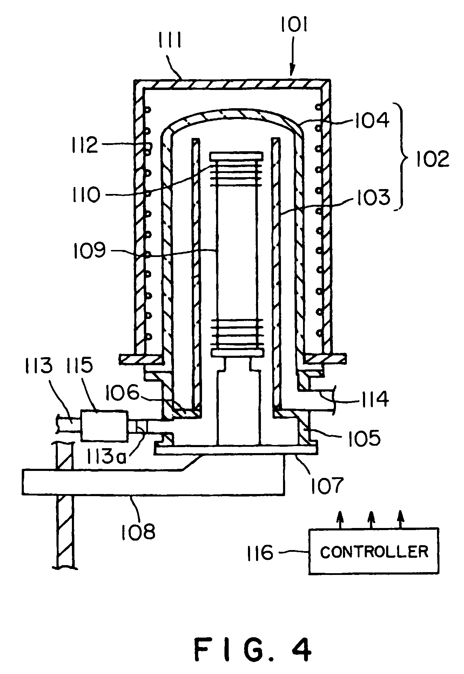

The second embodiment of the heat treatment apparatus and the cleaning method relating to the present invention will be described hereunder using an example of a case that a pollutant adhered to a semiconductor wafer is removed using the batch type vertical heat treatment apparatus shown in Fig. 4.

As shown in Fig. 4, a heat treatment apparatus 101 has a substantially cylindrical reaction tube (treatment vessel) 102 with the longitudinal direction directed vertically. The reaction tube 102 is composed of a double-tube structure composed of an inner tube 103 and an outer tube 104 having a ceiling, which covers the inner tube 103 and is formed so as to have a fixed gap with the inner tube 103. The inner tube 103 and the outer tube 104 are formed by a heat insulating material, for example, quartz.

Under the outer tube 104, a cylindrical manifold 105 made of stainless steel (SUS) is arranged. The manifold 105 is air tightly connected to the lower end of the outer tube 104. The inner tube 103 is supported by a support ring 106 which projects from the inner wall of the manifold 105 and is formed integratedly with the manifold 105.

A cover 107 is provided under the manifold 105. The cover 107 is so structured as to move up and down by a boat elevator 108. When the cover 107 moves up by the boat elevator 108, the cover 107 comes into contact with the manifold 105 and the reaction tube 102 is closed tightly.

On the cover 107, a wafer boat (holding tool for articles to be processed) 109, for example, made of quartz is loaded. A plurality of objects to be processed, for example, semiconductor wafers 110 are contained vertically at a predetermined interval in the wafer boat 109.

A heat insulator 111 is installed so as to surround the reaction tube 102. A temperature raising heater (treatment vessel heater) 112 composed of, for example, a heating resistor is installed on the inner wall surface of the insulator 111.

A cleaning gas introduction tube (cleaning gas feed means) 113 is connected to the side of the manifold 105. The cleaning gas introduction tube 113 is connected to a portion of the manifold 105 under the support ring 106, for example, so as to face to the inner tube 103. Cleaning gas introduced from the cleaning gas introduction tube 113, for example, hydrochloric (HCl) gas and nitrogen (N₂) gas as diluent gas are fed in the inner tube 103 into the reaction tube 102. In the side of the manifold 105, a processing gas introduction tube not shown in the drawing is connected to the reaction tube 102. Various processes such as forming a thin film on each of the semiconductor wafers 110 are performed by processing gas introduced from the processing gas introduction tube.

A heater (cleaning gas heater) 115 is connected to the cleaning gas introduction tube 113. The heater 115 has a heater composed of, for example, a heating resistor and heats cleaning gas fed into the heater 115 to a predetermined temperature.

An ejection port 114 is formed on the manifold 105. The ejection port 114 is provided above the support ring 106 and communicates with the space formed between the inner tube 103 and the outer tube 104 in the reaction tube 102. The cleaning gas is fed into the inner tube 103 from the cleaning gas introduction tube 113, and the removal process of a pollutant adhered to the surface of each of the semiconductor wafers 110 is performed, and reaction products generated by the removal process are ejected from the ejection port 114 through the gap between the inner tube 103 and the outer tube 104.

A controller 116 is connected to the boat elevator 108, the temperature raising heater 112, the cleaning gas introduction tube 113, and the heater 115. The controller 116 is composed of a microprocessor and a process controller, measures the temperature and pressure of each unit of the heat treatment apparatus 101, outputs a control signal to each unit mentioned above on the basis of the measured data, and controls each unit of the heat treatment apparatus 101.

Next, the cleaning method for the semiconductor wafers 110 using the heat treatment apparatus 101 structured as mentioned above will be explained using an example of a case that a pollutant adhered to the surface of each of the semiconductor wafers 110 is removed by hydrochloric gas (cleaning gas). In the following explanation, the operation of each unit constituting the heat treatment apparatus 101 is controlled by the controller 116.

Firstly, the heater 115 is heated to a predetermined temperature. The temperature of the heater 115 may be a temperature for activating cleaning gas fed into the heater 115 and in the case of cleaning gas including hydrochloric gas like this embodiment, the temperature of the heater 115 is preferable to be 800°C or more. In this embodiment, the heater 115 is heated to 1000°C.

Further, the reaction tube 102 is internally heated to a predetermined temperature by the temperature raising heater 112. The temperature in the reaction tube 102 may be a temperature for keeping the activation state of the cleaning gas fed from the cleaning gas introduction tube 113, and in the case of the cleaning gas including hydrochloric gas like this embodiment, it is preferable to be 700°C or more. However, an extremely small quantity of heavy metal (a pollutant) such as aluminum, iron, or copper is included in the quartz of the inner tube 103, and when the reaction tube 102 is internally heated to a temperature higher than 1000°C, there is a possibility that a pollutant may be emitted from quartz. Therefore, in this embodiment, the reaction tube 102 is internally heated to 800°C.

Next, in the state that the cover 107 is lowered by the boat elevator 108, the wafer boat 109 having the contained semiconductor wafers 110 is loaded on the cover 107. Next, the cover 107 is moved up by the boat elevator 108 and the wafer boat 109 (the semiconductor wafers 110) is loaded in the reaction tube 102. By doing this, the semiconductor wafers 110 are contained in the inner tube 103 of the reaction tube 102 and the reaction tube 102 is closed tightly.

After the reaction tube 102 is closed tightly, the cleaning gas at a predetermined flow rate is fed from the cleaning gas introduction tube 113 into the heater 115. In this embodiment, hydrochloric gas of 0.5 l/min and nitrogen (N₂) gas of 10 l/min are fed. Hydrochloric gas fed to the heater 115 is heated and activated in the heater 115. Then the gas is fed into the cleaning gas introduction tube 113 in the activated state, and introduced into the inner tube 103. In this case, the reaction tube 102 is internally heated to the temperature for keeping the activation state of the cleaning gas, so that hydrochloric gas is fed to the surface of each of the semiconductor wafers 110 in the activated state.

When the activated hydrochloric gas is fed to the surface of each of the semiconductor wafers 110, a pollutant (for example, iron) adhered to the surface of each of the semiconductor wafers 110 and chlorine in hydrochloric gas are reacted with each other and chloride (for example, iron chloride (FeCl₂), iron trichloride (FeCl₃) is produced. In this case, the hydrochloric gas fed to the surface of each of the semiconductor wafers 110 is activated, so that the reaction of chlorine in hydrochloric gas with the pollutant is promoted and the removal efficiency of a pollutant can be improved.

The produced chloride is ejected from the heat treatment apparatus 101 via the ejection port 114. When the chlorine gas is fed for a predetermined time, for example, 15 minutes, the pollutant adhered to the surface of each of the semiconductor wafers 110 is almost removed and the semiconductor wafers 110 are cleaned.

When the semiconductor wafers 110 are cleaned, the feed of the chlorine gas from the cleaning gas introduction tube 113 is stopped. Next, a predetermined amount of nitrogen gas, for example, 20 l/min is fed from the cleaning gas introduction tube 113. It is preferable to repeat feed and ejection of gas in the reaction tube 102 to surely eject non-reacted hydrochloric gas in the reaction tube 102.

After non-reacted hydrochloric gas is ejected from the reaction tube 102, various processes such as forming a silicone oxide film on each of the cleaned semiconductor wafers 110 are performed. When various processes are performed for the semiconductor wafers 110, the cover 107 is moved down by the boat elevator 108 and the wafer boat 109 (semiconductor wafers 110) is unloaded from the reaction tube 102. Then, the next semiconductor wafers 110 are contained in the wafer boat 109, and the wafer boat 109 is loaded in the reaction tube 102, and the same process is repeated.

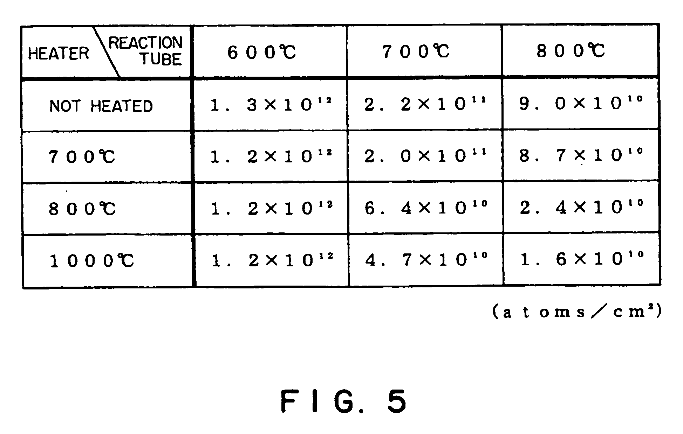

Next, to ascertain the effects of this embodiment, 1 x 10¹³ of iron (atoms/cm²) as a pollutant is adhered to the semiconductor wafers 110 and the semiconductor wafers 110 are cleaned. Hydrochloric gas of 0.5 l/min and nitrogen gas of 10 l/min are fed into the reaction tube 102 from the cleaning gas introduction tube 113 for 15 minutes to clean the semiconductor wafers 110. The relationship between the heating temperature (not heated, 700°C, 800°C, 1000°C) of the heater 115 and the temperature (600°C, 700°C, 800°C) in the reaction tube 102 is studied. The results are shown in Fig. 5.

As shown in Fig. 5, in the case that the temperature in the reaction tube 102 is 700°C or higher, when the heating temperature of the heater 115 is set to 800°C or higher and the cleaning gas is heated, as compared with a case that cleaning gas is not heated by the heater 115, it is ascertained that the amount of iron adhered to the semiconductor wafers 110 can be reduced greatly. The reason is that by heating cleaning gas to 800°C by the heater 115, chlorine gas can be activated and chlorine gas can be kept in the activated state in the reaction tube 102 by setting the temperature in the reaction tube 102 to 700°C or higher.

In the case that the temperature in the reaction tube 102 is 800°C, even if the heating temperature of the heater 115 is set to 700°C and the cleaning gas is heated, chlorine gas fed into the reaction tube 102 is not activated and as compared with a case that cleaning gas is not heated by the heater 115, the amount of iron adhered to the semiconductor wafers 110 cannot be reduced. Further, in the case that the temperature in the reaction tube 102 is 600°C, even if the heating temperature of the heater 115 is set to 1000°C and the cleaning gas is heated, activated chlorine gas cannot be kept activated in the reaction tube 102 and as compared with a case that cleaning gas is not heated by the heater 115, the amount of iron adhered to the semiconductor wafers 110 cannot be reduced.

As mentioned above, when the chlorine gas is activated by the heater 115 and the chlorine gas is kept activated in the reaction tube 102, as compared with a case that cleaning gas is not heated by the heater 115, the amount of iron adhered to the semiconductor wafers 110 can be reduced greatly and the removal effect of iron (pollutant) can be improved.

When the flow rate of hydrochloric gas from the cleaning gas introduction tube 113 is doubled such as from 0.5 l/min to 1 l/min and also when the feed time of the hydrochloric gas from the cleaning gas introduction tube 113 is doubled such as from 15 minutes to 30 minutes, the semiconductor wafers 110 are cleaned in the same way and the flow rate and feed time of hydrochloric gas from the cleaning gas introduction tube 113 are studied. It can be ascertained that the cleaning effect is little affected by the flow rate and feed time of hydrochloric gas and almost the same results are obtained.

As explained above, according to this embodiment, when the heating temperature of the heater 115 is set to 800°C or higher, and the hydrochloric gas is activated, and the temperature in the reaction tube 102 is set to 700oC or higher, and hydrochloric gas is kept activated, as compared with a case that cleaning gas is not heated by the heater 115, the amount of iron adhered to the semiconductor wafers 110 can be reduced greatly and the removal effect of iron can be improved.

The present invention is not limited to the embodiment aforementioned, but can be applied to for example, the following case.

In this embodiment, the present invention is explained using hydrochloric gas as cleaning gas for removing a pollutant adhered to the semiconductor wafers 110. However various cleaning gases can be added to the hydrochloric gas depending on a pollutant. In this case, it is desirable that the temperature of the heater 115 is a temperature for activating cleaning gas fed into the heater 115 and the temperature in the reaction tube 102 is a temperature for keeping the activated state of the cleaning gas. The temperatures thereof vary with the kind of cleaning gas to be used.

Cleaning gas including hydrochloric gas may be mixed gas of, for example, hydrochloric gas and dichloroethylene gas (C₂H₂Cl₂). Furthermore, oxygen gas may be mixed with hydrochloric gas. In this case, even if a pollutant is an oxide, it can be ejected from the heat treatment apparatus 101 and the removal efficiency of a pollutant can be improved. However, it is preferable to severely control the cleaning conditions for the semiconductor wafers 110 so as to prevent the surface of each of the semiconductor wafers 110 from having an unnecessary oxide film.

In this embodiment, the present invention is explained using an example of iron as the pollutant. However, the pollutant may be copper (Cu), aluminum (Al), or tungsten (W) in addition to iron. Even when any of them is used, the removal effect can be improved in the same way as with iron.

In this embodiment, the present invention is explained using an example of a case that nitrogen gas is used as diluent gas for hydrochloric gas. However, diluent gas may be gas having no reactivity with hydrochloric gas. For example, inactive gas such as argon (Ar) gas may be used.

On the downstream side of the heater 115 of the cleaning gas introduction tube 113, an orifice 113a for narrowing the inner diameter of the cleaning gas introduction tube 113 may be provided. In this case, cleaning gas passing inside the heater 115 is given a sufficient retention time and the heating efficiency by the heater 115 is improved. As a result, the removal efficiency of a pollutant adhered to the semiconductor wafers 110 can be improved more. Further, the heating temperature of the heater 115 can be lowered.

In this embodiment, the batch type vertical heat treatment apparatus is explained. However, the present invention is not limited to this apparatus and can be applied also, for example, to a single-wafer processing type heat treatment apparatus. Objects to be processed are not limited to semiconductor wafers and may be applied to LCD glass substrates.

As explained above, according to the present invention, the removal efficiency of a pollutant adhered to articles to be processed can be improved.

## Claims

1. A cleaning method of a heat treatment apparatus for feeding cleaning gas in a treatment vessel containing an object to be processed and removing a pollutant on said object to be processed in said treatment vessel, comprising the steps of:
preheating said cleaning gas up to an activation capability temperature of said cleaning gas outside said treatment vessel and
feeding said preheated cleaning gas into said treatment vessel and heating and keeping said treatment vessel internally at a predetermined temperature, **characterized in that** said cleaning gas includes a hydrochloric acid, and is heated up to an activation capability temperature of said hydrochloric acid of at least 800°C, and
said treatment vessel is heated and kept internally at 700°C to 1000°C.

2. The cleaning method of a heat treatment apparatus according to Claim 1, wherein said pollutant on said object to be processed is at least one of iron, copper, aluminum, and tungsten.

3. The cleaning method of a heat treatment apparatus according to Claim 1 or 2, wherein said treatment vessel is heated and kept at said predetermined temperature in a state that a holding tool of an object to be processed is contained in said treatment vessel.

4. The cleaning method for a heat treatment apparatus according to one of the preceding claims, wherein
the treatment vessel is made of quartz or SiC.

5. A heat treatment apparatus comprising:
a treatment vessel having a holding tool for an object to be processed,
a treatment vessel heater arranged outside said treatment vessel for heating said treatment vessel,
cleaning gas feed means for feeding cleaning gas into said treatment vessel, and
a cleaning gas heater connected to said cleaning gas feed means for preheating said cleaning gas outside said treatment vessel,
wherein said cleaning gas heater and said treatment vessel heater are controlled by control means; **characterized in that**
said cleaning gas includes a hydrochloric acid, and
said control means controls said cleaning gas heater so as to heat said cleaning gas up to said activation capability temperature of at least 800°C, and controls said treatment vessel heater so as to heat said treatment vessel to 700°C to 1000°C, so that a pollutant on said object to be processed is removed.

6. The heat treatment apparatus according to Claim 5, wherein
said object to be processed is held by said holding tool.

7. The heat treatment apparatus according to Claim 5 or 6, wherein
said pollutant on said object to be processed is at least one of iron, copper, aluminum, and tungsten.

8. The heat treatment apparatus according to one of Claims 5 to 7, wherein
said treating vessel is composed of an inner tube for containing said object to be processed and an outer tube having a ceiling covering said inner tube, and
cleaning feed means is interconnected into said inner tube.

9. The heat treatment apparatus according to one of Claims 5 to 8, wherein
on a downstream side of said cleaning gas heater, an orifice is installed to give a flow path resistance to said cleaning gas.

## Patentansprüche

1. Reinigungsverfahren für eine Wärmebehandlungsvorrichtung zum Speisen von Reinigungsgas in ein Behandlungsgefäß, welches einen zu behandelnden Gegenstand enthält, und Entfernen eines Schadstoffes auf dem zu behandelnden Objekt in dem Behandlungsgefäß umfassend die Schritte:
Vorwärmen des Reinigungsgases außerhalb des Behandlungsgefäßes bis auf eine Temperatur, welche das Reinigungsgas zur Wirksamkeit aktiviert, und
Speisen des vorgewärmten Reinigungsgases in das Behandlungsgefäß und Heizen und Halten des Reinigungsgefäßes auf einer vorbestimmten Temperatur, **dadurch gekennzeichnet, daß**
das Reinigungsgas Salzsäure enthält und auf eine Aktivierungstemperatur der Salzsäure von mindestens 800°C aufgeheizt wird und
das Behandlungsgefäß innen auf eine Temperatur von 700°C bis 1000°C aufgeheizt und auf dieser Temperatur gehalten wird.

2. Reinigungsverfahren nach Anspruch 1, bei der der Schadstoff auf dem zu behandelnden Objekt mindestens eines der Metalle Eisen, Kupfer, Aluminium, Wolfram enthält.

3. Reinigungsverfahren nach Anspruch 1 oder 2, bei dem das Behandlungsgefäß auf die vorbestimmte Temperatur aufgeheizt und auf dieser Temperatur in einem Zustand gehalten wird, in welchem ein Haltewerkzeug für das zu behandelnde Objekt in dem Behandlungsgefäß vorgesehen ist.

4. Reinigungsverfahren nach einem der vorangehenden Ansprüche, bei dem das Behandlungsgefäß aus Quarz oder SiC hergestellt wird.

5. Wärmebehandlungsvorrichtung, die umfaßt:
ein Behandlungsgefäß mit einem Haltewerkzeug für ein zu behandelndes Objekt, einen außerhalb des Behandlungsgefäßes angeordneten Behandlungsgefäßheizer zum Heizen des Behandlungsgefäßes,
eine Reinigungsgas-Speisevorrichtung zum Speisen von Reinigungsgas in das Behandlungsgefäß und einen Reinigungsgasheizer, der mit der Reinigungsgas-Speisevorrichtung zum Vorwärmen des Reinigungsgases außerhalb des Behandlungsgefäßes verbunden ist,
wobei der Reinigungsgasheizer und der Behandlungsgefäßheizer von einer Steuervorrichtung gesteuert sind; **dadurch gekennzeichnet, daß**
das Reinigungsgas Salzsäure enthält und
die Steuervorrichtung den Reinigungsgasheizer so steuert, daß das Reinigungsgas auf eine Aktivierungstemperatur von mindestens 800°C aufgeheizt wird, und den Behandlungsgasheizer so steuert, daß das Behandlungsgefäß auf 700°C bis 1000°C aufgeheizt wird, so daß ein Schadstoff auf dem zu behandelnden Objekt entfernt wird.

6. Wärmebehandlungsvorrichtung nach Anspruch 5, bei dem das zu behandelnde Objekt von dem Haltewerkzeug gehalten ist.

7. Wärmebehandlungsvorrichtung nach Anspruch 5 oder 6, bei dem der Schadstoff auf dem zu behandelnden Objekt mindestens eines der Metalle Eisen, Kupfer, Aluminium, Wolfram enthält.

8. Wärmebehandlungsvorrichtung nach einem der Ansprüche 5 bis 7, bei dem das Behandlungsgefäß aus einem Innenrohr zum Aufnehmen des zu behandelnden Objektes und einem Außenrohr mit einer das Innenrohr abdeckenden Decke zusammengesetzt ist, und daß die Reinigungsgas-Speisevorrichtung mit dem Innenrohr verbunden ist.

9. Wärmebehandlungsvorrichtung nach einem der Ansprüche 5 bis 8, bei dem auf der Abstromseite des Reinigungsgasheizers eine Lochblende zum Erzeugen eines Strömungswiderstandes für das Reinigungsgas installiert ist.

## Revendications

1. Procédé de nettoyage d'un dispositif de traitement thermique pour délivrer un gaz de nettoyage dans un récipient de traitement contenant un objet devant être traité et éliminer un polluant sur ledit objet devant être traité dans ledit récipient de traitement, comprenant les étapes de :
préchauffage dudit gaz de nettoyage jusqu'à une température de capacité d'activation dudit gaz de nettoyage à l'extérieur dudit récipient de traitement, et
introduction dudit gaz de nettoyage préchauffé dans ledit récipient de traitement et chauffage et maintien dudit récipient de traitement en interne à une température prédéterminée,
**caractérisé en ce que** ledit gaz de nettoyage comprend de l'acide chlorhydrique, et est chauffé jusqu'à une température de capacité d'activation dudit acide chlorhydrique, d'au moins 800°C, et
ledit récipient de traitement est chauffé et maintenu en interne entre 700°C et 1000°C.

2. Procédé de nettoyage d'un dispositif de traitement thermique selon la revendication 1, dans lequel ledit polluant sur ledit objet devant être traité est au moins l'un parmi le fer, le cuivre, l'aluminium, et le tungstène.

3. Procédé de nettoyage d'un dispositif de traitement thermique selon la revendication 1 ou 2, dans lequel ledit récipient de traitement est chauffé et maintenu à ladite température prédéterminée dans un état où un outil de retenue d'un objet devant être traité est contenu dans ledit récipient de traitement.

4. Procédé de nettoyage pour un dispositif de traitement thermique selon l'une des revendications précédentes, dans lequel le récipient de traitement est fait en quartz ou en Sic.

5. Dispositif de traitement thermique comprenant :
un récipient de traitement ayant un outil de retenue pour un objet devant être traité,
un réchauffeur de récipient de traitement agencé à l'extérieur dudit récipient de traitement pour chauffer ledit récipient de traitement,
un moyen de délivrance de gaz de nettoyage pour introduire du gaz de nettoyage dans ledit récipient de traitement, et
un réchauffeur de gaz de nettoyage connecté audit moyen de délivrance de gaz de nettoyage pour préchauffer ledit gaz de nettoyage à l'extérieur dudit récipient de traitement,
dans lequel ledit réchauffeur de gaz de nettoyage et ledit réchauffeur de récipient de traitement sont commandés par des moyens de commande ;
**caractérisé en ce que**
ledit gaz de nettoyage comprend de l'acide chlorhydrique, et
ledit moyen de commande commande ledit réchauffeur de gaz de nettoyage de manière à chauffer ledit gaz de nettoyage jusqu'à ladite température de capacité d'activation, d'au moins 800°C, et commande ledit réchauffeur de récipient de traitement de façon à chauffer ledit récipient de traitement entre 700°C et 1000°C, de façon qu'un polluant sur ledit objet devant être traité soit éliminé.

6. Dispositif de traitement thermique selon la revendication 5, dans lequel ledit objet devant être traité est maintenu par ledit outil de retenue.

7. Dispositif de traitement thermique selon la revendication 5 ou 6, dans lequel ledit polluant sur ledit objet devant être traité est au moins l'un parmi le fer, le cuivre, l'aluminium, et le tungstène.

8. Dispositif de traitement thermique selon l'une des revendications 5 à 7, dans lequel ledit récipient de traitement est composé d'un tube intérieur pour contenir ledit objet devant être traité et d'un tube extérieur ayant un plafond recouvrant ledit tube intérieur, et ledit moyen de délivrance de nettoyage est interconnecté dans ledit tube intérieur.

9. Dispositif de traitement thermique selon l'une des revendications 5 à 8, dans lequel, sur le côté aval dudit réchauffeur de gaz de nettoyage, est installé un orifice pour doter ledit gaz de nettoyage d'une résistance au trajet d'écoulement.
